# EUROPEAN PATENT APPLICATION

(11) **EP 3 671 834 A1**
(43) Date of publication of application: **24.06.2020**
(21) Application number: 19209587.5
(22) Date of filing: 15.11.2019
(51) Int. Cl.: H01L 27/02, H01L 29/06

(54) **LATCHUP GUARD RING GRID**

(30) Priority: 17.12.2018 US 201816222265
(71) Applicant: Intel Corporation, Santa Clara, CA 95054-1549 (US)
(72) Inventor: JACK, Nathan, Forest Grove, Oregon 97116 (US); DOMANSKI, Krzysztof, 85579 Neubiberg (DE)
(74) Representative: HGF Limited

(57) **Abstract**

A guard ring grid is disclosed. The guard ring grid includes a substrate and an injector array coupled to the substrate. The injector array includes a plurality of injectors. The guard ring grid also includes a plurality of guard rings that surround the plurality of injectors.

## Description

### TECHNICAL FIELD

Embodiments of the disclosure pertain to guard rings and, in particular, to latchup type guard ring grids.

### BACKGROUND

Guard ring design and integration is a fundamental design synthesis practice in semiconductor design. Guard rings are used in various places in a semiconductor chip in order to provide electrical isolation of circuit functions. Guard rings are used to prevent undesirable interaction between devices, circuits, sub-functions, and power domains. A guard ring prevents both current injection and potential perturbations that can lead to parasitic devices, noise, electrostatic discharge (ESD) failure, and latchup. In guard ring design, issues include the guard ring placement and guard ring effectiveness. Guard ring placement relates to where guard rings are to be placed around a given device, circuit, sub-function, or function. Guard rings are placed wherever concerns of parasitic interaction, noise, ESD, or latchup can occur. Guard ring placement is a fundamental part of latchup physics, latchup characterization, and latchup analysis. In semiconductor chips, latchup performance deteriorates significantly with the introduction of high-resistance substrates. Moreover, scaling exacerbates the deterioration.

Forming guard rings around the perimeter of I/O-pad-connected diffusions (injectors) is a conventional industry practice for latchup mitigation. Guard rings consist of a p+ diffusion in a pwell that surrounds p-type injectors or an n+ diffusion in an nwell that surrounds n-type injectors. In a previous approach to improve the collection efficiency of n-type guard rings, a deep nwell (DNW) region that terminates at the guard ring has been implemented. However, because guard rings are placed around the perimeter of an array of injector devices, collection efficiency is lower for diffusions in the center of an injector device array. This is because the injected carrier collecting potential that is provided by the guard ring drops as the distance from the guard ring increases. Thus, because the injected carrier collecting force of the guard ring becomes weaker the further the injecting diffusion is from the guard ring, a higher percentage of injected carriers escape collection the further the injecting diffusion region is from the guard ring. Consequently, larger arrays that include injecting diffusion regions that are located significant distances from the guard rings suffer excessive levels of injected carrier escape.

In a previous approach, to address the escape of injected carriers, a deep nwell (DNW) is formed underneath the n-type injectors of an injector array. Using this approach, the efficiency of injected carrier collection is increased. Although forming a DNW underneath n-type injectors can increase efficiency, injected carriers can still escape. For example, the current collected by the DNW in the center of the array can cause a resistive voltage drop that can de-bias the DNW and enable the escape of carriers. It should be appreciated that a heavier doping of the DNW does not prevent the resistive drop from occurring and can instead cause increased junction leakage and decreased well breakdown voltages.

### BRIEF DESCRIPTION OF THE DRAWINGS

Embodiments of the invention will now be described, by way of example only, with reference to the accompanying drawings in which:
FIG. 1A is an illustration of a top view of a semiconductor structure that includes a guard ring of a previous approach.
FIG. 1B is an illustration of a cross-sectional view of the semiconductor structure that includes a guard ring of FIG. 1A.
FIG. 2 is an illustration of a cross-sectional view of a semiconductor structure that includes a guard ring of a previous approach.
FIGS. 3A-3C show top views of semiconductor structures that includes guard rings that illustrate differences between previous approaches and the approach of an embodiment.
FIG. 4 is an illustration of a cross-sectional view of a semiconductor structure that includes a guard ring grid according to an embodiment.
FIG. 5A is an illustration of a cross-sectional view of a semiconductor structure that includes a guard ring grid according to an embodiment.
FIG. 5B is an illustration of an electronic system that includes a guard ring grid according to an embodiment.
FIG. 6 is a graph of distance to guard ring versus improvement in trigger current for a plurality of types of devices according to an embodiment.
FIG. 7 is a graph that shows the relative injected current collected for a plurality of types of devices according to an embodiment.
FIG. 8 shows a flowchart of a method for forming a latchup guard ring grid according to an embodiment.
FIG. 9 illustrates a computing device in accordance with one implementation of the invention.
FIG. 10 illustrates an interposer that includes one or more embodiments of the invention.

### DESCRIPTION OF THE EMBODIMENTS

Various respective aspects and features of the invention are defined in the appended claims. Combinations of features from the dependent claims may be combined with features of the independent claims as appropriate and not merely as explicitly set out in the claims.

A latchup type guard ring is described. It should be appreciated that although embodiments are described herein with reference to example latchup type guard rings, the disclosure is more generally applicable to latchup type guard rings as well as other latchup type guard rings. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

In a previous approach, to address the escape of injected carriers, a deep nwell (DNW) is formed underneath the n-type injectors of an injector array. Using this approach, the efficiency of injected carrier collection can increased. Although forming a DNW underneath n-type injectors can increase efficiency, injected carriers can still escape. For example, the current collected by the DNW in the center of the array can cause a resistive voltage drop that can de-bias the DNW and enable carriers to escape. It should be appreciated that heavier doping of the DNW does not prevent the resistive voltage drop from occurring and can instead cause increased junction leakage and decreased well breakdown voltages.

An approach that addresses the shortcomings of previous approaches is disclosed herein. As a part of an injector array embodiment, a guard ring grid is provided that integrates individual guard rings to surround individual injectors of the injector array rather the perimeter of the injector array. In particular, the injector array (e.g., ESD diodes or output drivers) is divided into segments that are surrounded by guard rings to form the guard ring grid. In this manner, the injector-to-guard-ring distance is significantly reduced and collection efficiency improved.

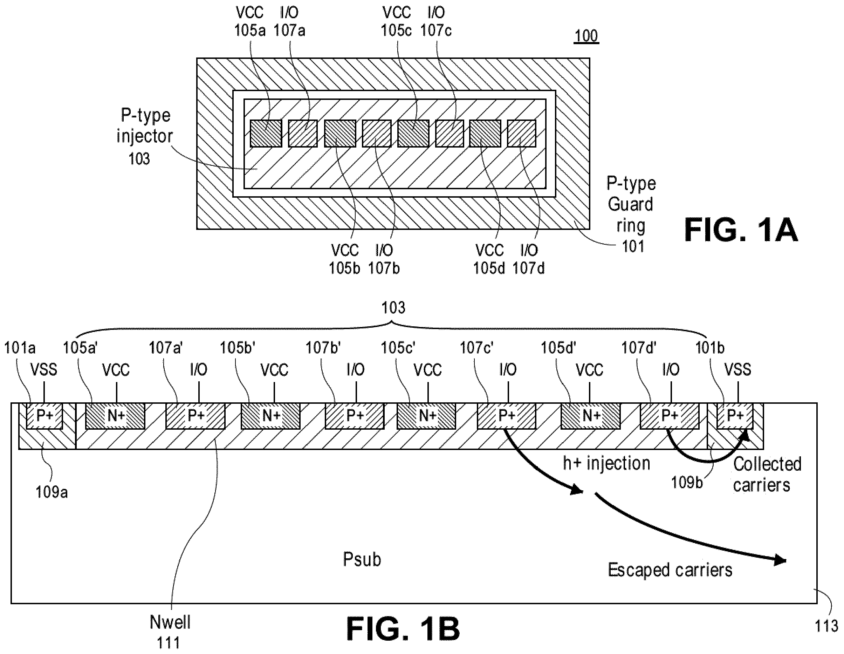

FIG. 1A is an illustration of a top view of a semiconductor structure 100 that includes a p-type guard ring of a previous approach. FIG. 1A shows p-type guard ring 101, p-type injector 103, VCC terminal 105a, VCC terminal 105b, VCC terminal 105c, VCC terminal 105d, input(I)/output(O) terminal 107a, I/O terminal 107b, I/O terminal 107c and I/O terminal 107d.

Referring to FIG. 1A, the p-type guard ring 101 surrounds p-type injector 103. The p-type injector 103 includes the VCC terminal 105a, the VCC terminal 105b, the VCC terminal 105c, and the VCC terminal 105d. The p-type injector 103 also includes the I/O terminal 107a, the I/O terminal 107b, the I/O terminal 107c and the I/O terminal 107d. In an embodiment, the VCC terminal 105a, the VCC terminal 105b, the VCC terminal 105c, and the VCC terminal 105d are respectively formed adjacent the I/O terminal 107a, the I/O terminal 107b, the I/O terminal 107c and the I/O terminal 107d (and vice versa).

FIG. 1B is an illustration of a cross-sectional view of the semiconductor structure 100 of FIG. 1A. FIG. 1B shows p-type guard ring cross-sections 101a and 101b, n-type VCC diffusion region 105a', n-type VCC diffusion region 105b', n-type VCC diffusion region 105c', n-type VCC diffusion region 105d', p-type I/O injector region 107a', p-type I/O injector region 107b', p-type I/O injector region 107c', p-type I/O injector region 107d', pwells 109a and 109b, nwell 111 and substrate 113.

Referring to FIG. 1B, the p-type guard ring 101a and 101b surrounds p-type injector array 103. The p-type injector array 103 includes the VCC diffusion region 105a', the VCC diffusion region 105b', the VCC diffusion region 105c', and the VCC diffusion region 105d'. The p-type injector array 103 also includes the p-type I/O injector region 107a', the p-type I/O injector region 107b', the p-type I/O injector region 107c' and the p-type I/O injector region 107d'. In an embodiment, the n-type VCC diffusion region 105a', the n-type VCC diffusion region 105b', the n-type VCC diffusion region 105c', and the n-type VCC diffusion region 105d' are respectively formed adjacent the p-type I/O injector region 107a', the p-type I/O injector region 107b', the p-type I/O injector region 107c' and the p-type I/O injector region 107d'. In an embodiment, the n-type VCC diffusion region 105a', the n-type VCC diffusion region 105b', the n-type VCC diffusion region 105c', the n-type VCC diffusion region 105d', the p-type I/O injector region 107a', the p-type I/O injector region 107b', the p-type I/O injector region 107c' and the p-type I/O injector region 107d' are formed in the nwell 111. The p-type guard ring components 101a and 101b are formed in/above the p-type substrate 109 and extend into pwells 109a and 109b. The nwell 111 extends from the surface of the substrate 109 into the upper body of the substrate 113.

Referring again to FIG. 1B, the p-type guard ring 101 with cross-sections 101a and 101b is formed around the perimeter of I/O-terminal-connected diffusions, e.g., p-type I/O injector regions 107a'-107d', for latchup mitigation. The p-type guard ring 101 with cross-sections 101a and 101b consist of p+ diffusion pwell that surrounds p-type I/O injector regions 107a'-107d'. Because the p type guard ring 101 is formed around the perimeter of p-type I/O injector regions 107a'-107d', collection efficiency is lower for injector regions in or near the center of the injector array as compared to injector regions located closer to the perimeter. This is because a higher percentage of injected carriers will escape collection the further the p-type I/O injector regions 107a'-107d' is from the p-type guard ring 101 with cross-sections 101a and 101b'. Consequently, the performance of guard rings configured as shown in FIG. 1B suffer in larger arrays that include injector regions that are located away from the array periphery.

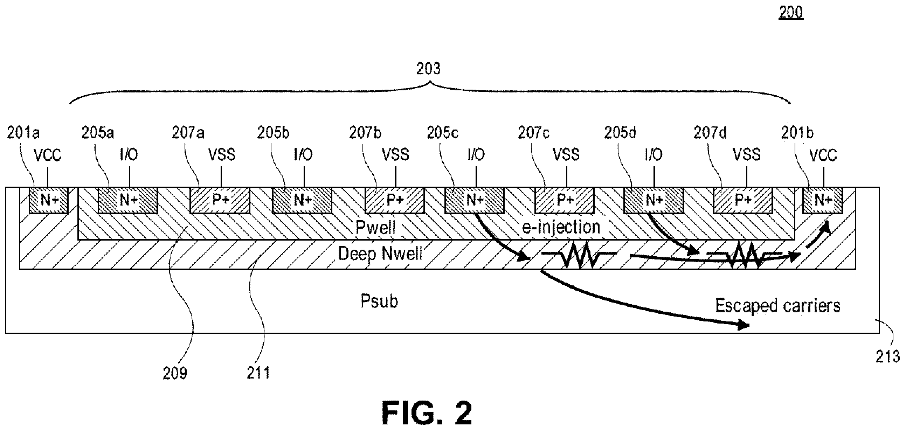

FIG. 2 is an illustration of a cross-sectional view of a semiconductor structure 200 that includes an n-type guard ring of a previous approach. FIG. 2 shows n-type guard ring cross-sections 201a and 201b, n-type injector array 203, n-type I/O injector region 205a, n-type I/O region 205b, n-type I/O injector region 205c, n-type I/O injector region 205d, p-type VSS diffusion region 207a, p-type VSS diffusion region 207b, p-type VSS diffusion region 207c, p-type VSS diffusion region 207d, pwell 209, deep nwell 211, and p-type substrate 213.

Referring to FIG. 2, the n-type guard ring 201 with cross-sections 201a and 201b surrounds injector 203 array. The n-type injector array 203 includes the n-type I/O injector region 205a, the n-type I/O injector region 205b, the n-type I/O injector region 205c and the n-type I/O injector region 205d. The injector array 203 also includes the p-type VSS diffusion region 207a, the p-type VSS diffusion region 207b, the p-type VSS diffusion region 207c, and the p-type VSS diffusion region 207d. In an embodiment, the n-type I/O injector region 205a, the n-type I/O injector region 205b, the n-type I/O injector region 205c and the n-type I/O injector region 205d are respectively formed adjacent the p-type VSS diffusion region 207a, the p-type VSS diffusion region 207b, the p-type VSS diffusion region 207c, and the p-type VSS diffusion region 207d. In an embodiment, the n-type I/O injector region 205a, the n-type I/O injector region 205b, the n-type I/O injector region 205c, the n-type I/O injector region 205d, the p-type VSS diffusion region 207a, the p-type VSS diffusion region 207b, the p-type VSS diffusion region 207c, and the p-type VSS diffusion region 207d extend into the pwell 209.The n-type guard ring 201 with cross-sections 201a and 201b extend into the deep nwell 211. The pwell 209 extends from the surface of the substrate 213 into the upper body of the substrate 213. The deep nwell 211 extends from the surface of the substrate 213 deep into the body of the substrate 213 and surrounds the pwell 209.

In an embodiment, the n-type guard ring 201 with cross-sections 201a and 201b can be formed from arsenic. In other embodiments, the n-type guard ring 201 with cross-sections 201a and 201b can be formed from other materials. In an embodiment, the n-type I/O injector regions 205a, n-type I/O injector region 205b, the n-type I/O injector region 205c, and the n-type I/O injector region 205d can be formed from phosphorous. In other embodiments, the n-type I/O injector region 205a, the n-type I/O region 205b, the n-type I/O injector region 205c, and the n-type I/O injector region 205d can be formed from other materials. In an embodiment, the p-type VSS diffusion region 207a, the p-type VSS diffusion region 207b, the p-type VSS diffusion region 207c and the p-type VSS diffusion region 207d can be formed from boron. In other embodiments, the p-type VSS diffusion region 207a, the p-type VSS diffusion region 207b, the p-type VSS diffusion region 207c and the p-type VSS diffusion region 207d can be formed from other materials. In an embodiment, the pwell 209 can be formed from boron. In other embodiments, the pwell 209 can be formed from other materials. In an embodiment, the deep nwell 211 can be formed from phosphorous. In other embodiments, the deep nwell 211 can be formed from other materials. In an embodiment, the substrate 213 can be formed from silicon. In other embodiments, the substrate 213 can be formed from other materials.

Referring again to FIG. 2, the n-type guard ring 201 with cross-sections 201a and 201b are formed around the perimeter of I/O-pad-connected diffusions, e.g., n-type I/O injector regions 205a-205d, for latchup mitigation. The n-type guard ring 201 with cross-sections 201a and 201b consist of n+ diffusions in nwells that surround n-type I/O injector regions 205a-205d. To improve the collection efficiency of the n-type guard ring 201 with cross-sections 201a and 201b, a deep nwell (DNW) that terminates at the guard ring is used. Because the n-type guard ring 201 with cross-sections 201a and 201b are placed around the perimeter of the n-type I/O injector regions 205a-205d, collection efficiency may be lower for injector regions in or near the center of the injector array as compared to injector regions closer to the perimeter of the injector array. This is because a higher percentage of injected carriers can escape the further the n-type I/O injector regions 205a-205d are from the n-type guard ring 201 with cross-sections 201a and 201b. Consequently, the performance of the n-type guard ring 201 with cross-sections 201a and 201b can suffer for a large n-type array 203 as regards I/O injector regions 205a-205n located away from the array periphery.

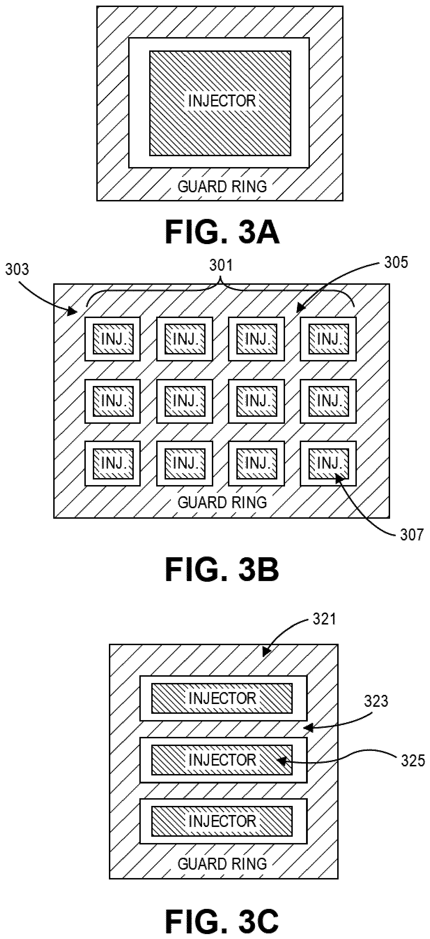

FIGS. 3A-3C show top views of semiconductor structures that illustrate differences between the approaches of FIG. 1A, FIG. 1B and FIG. 2, and the approach of an embodiment. FIG. 3A, shows the approach of FIGS. 1A, FIG. 1B and FIG. 2 that includes a guard ring that is formed around the periphery of an injector array. In contrast, in FIG. 3B, a guard ring grid 301 is formed that is characterized by both horizontal 303 and vertical 305 guard ring regions that surround injector regions 307 of an injector array. In FIG. 3C, a guard ring grid 321 is formed that is characterized by horizontal guard regions 323 between injector regions 325.

Referring to FIGS. 3B and FIG. 3C, in an embodiment the guard ring grids 301 and 321 are formed by surrounding individual injectors 307 and 325 of the injector arrays with guard rings rather than forming a single guard ring around the perimeter of the injector array. This is accomplished by dividing the injector array (e.g., ESD diodes or drivers) into segments that are surrounded by guard rings to form the guard ring grids 301 and 321. In this manner, as compared to previous approaches, the injector-to-guard-ring distance is significantly reduced. As a consequence the guard ring collection efficiency is significantly improved.

In an embodiment, the significant improvement in guard ring efficiency can result in latchup enforcement zone reductions of 50% or more. Such improvement in latchup robustness at the source of injection lessens the design burden on neighboring non-I/O blocks.

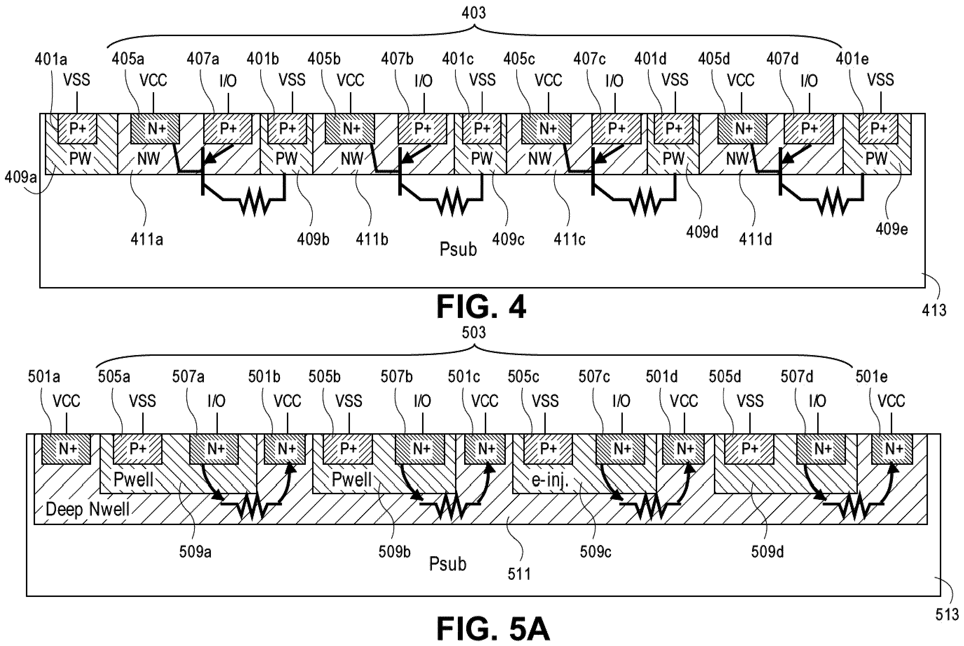

FIG. 4 is an illustration of a cross-sectional view of a semiconductor structure 400 that includes a p-type guard ring according to an embodiment. FIG. 4 shows p-type guard rings 401a-401e, p-type I/O injector array 403, n-type VCC diffusion region 405a, n-type VCC diffusion region 405b, n-type VCC diffusion region 405c, n-type VCC diffusion region 405d, p-type I/O injector region 407a, p-type I/O injector region 407b, p-type I/O injector region 407c, p-type I/O injector region 407d, pwells 409a-409e, nwells 411a-411d, and substrate 413.

Referring to FIG. 4, the p-type guard rings 401a and 401b extend into pwells 409a and 409b and surround the n-type VCC diffusion region 405a and the p-type I/O injector region 407a. The p-type guard rings 401b and 401c extend into pwells 409b and 409c and surround the n-type VCC diffusion region 405b and the p-type I/O injector region 407b. The p-type guard rings 401c and 401d extend into a pwells 409c and 409d and surround the n-type VCC diffusion region 405c and the p-type I/O injector region 407c. The p-type guard rings 401d and 401e extend into pwells 409d and 409e and surround the n-type VCC diffusion region 405d and the p-type I/O injector region 407d. The n-type VCC diffusion region 405a and p-type I/O injector region 407a extend into nwell 411a. The n-type VCC diffusion region 405b and the p-type I/O injector region 407b extend into nwell 411b. The n-type VCC diffusion region 405c and the p-type I/O injector region 407c extend into nwell 411c. The n-type VCC diffusion region 405d and the p-type I/O injector region 407d extend into nwell 411d.

In an embodiment, the p-type guard rings 401a-401e can be formed from boron. In other embodiments, the p-type guard rings 401a-401e can be formed from other materials. In an embodiment, the n-type VCC diffusion region 405a, the n-type VCC diffusion region 405b, the n-type VCC diffusion region 405c and the n-type VCC region 405d can be formed from phosphorous. In other embodiments, the n-type VCC diffusion region 405a, the n-type VCC diffusion region 405b, the n-type VCC diffusion region 405c, and the n-type VCC diffusion region 405d can be formed from other materials. In an embodiment, the p-type I/O injector regions 407a, the p-type I/O injector region 407b, the p-type I/O injector region 407c, the p-type I/O injector region 407d can be formed from boron. In other embodiments, the p-type I/O injector regions 407a, the p-type I/O injector region 407a, the p-type I/O injector region 407b, the p-type I/O injector region 407c, the p-type I/O injector region 407d can be formed from other materials. In an embodiment, the pwells 409a-409e can be formed from boron. In other embodiments, the pwells 409a-409e can be formed from other materials. In an embodiment, the nwells 411a-411d can be formed from phosphorous. In other embodiments, the nwells 411a-411d can be formed from other materials. In an embodiment, the substrate 413 can be formed from silicon. In other embodiments, the substrate 413 can be formed from other materials.

In operation, the guard ring grid operates to mitigate latch up based on an efficient collection of carriers. For example, rather than forming a single guard ring around each large injector array (e.g., ESD diode), the injector is separated into smaller parts where each injector of the injector array is surrounded by a guard ring to form a grid (see FIGS. 3B and 3C). Thus, the guard ring is integrated with the diode array rather than form a "fence" around it. The guard ring grid improves efficiency over standard perimeter-only guard rings because the bipolar junction transistor (BJT) gain between injector and guard ring is strengthened. The I/O node (emitter), the isolated well (base), and the guard ring well (collector) enclosing it form a parasitic BJT. The grid decreases the base width and improves collector efficiency by forming smaller BJTs.

FIG. 5A is an illustration of a cross-sectional view of a semiconductor structure 500 that includes n-type guard rings of an embodiment. FIG. 5A shows n-type guard rings 501a-501e, n-type injector 503 array, p-type VSS diffusion region 505a, p-type VSS diffusion region 505b, p-type VSS diffusion region 505c, p-type VSS diffusion region 505d, n-type I/O injector region 507a, n-type I/O injector region 507b, n-type I/O injector region 507c, n-type I/O injector region 507d, pwells 509a-509d, deep nwell 511, and substrate 513.

Referring to FIG. 5A, the n-type guard rings 501a and 501b extend into a deep nwell 511 and surround the p-type VSS diffusion region 505a and n-type I/O injector region 507a. The n-type guard rings 501b and 501c extend into the deep nwell 511 and surround the p-type VSS diffusion region 505b and the n-type I/O injector region 507b. The n-type guard rings 501c and 501d extend into the deep nwell 511 and surround the p-type VSS diffusion region 505c and the n-type I/O injector region 507c. The n-type guard rings 501d and 501e extend into the deep nwell 511 and surround the p-type VSS diffusion region 505d and the n-type I/O injector region 507d. The p-type VSS diffusion region 505a and n-type I/O injector region 507a extend into pwell 509a. The p-type VSS diffusion region 505b and the n-type I/O injector region 507b extend into pwell 509b. The p-type VSS diffusion region 505c and the n-type I/O injector region 507c extend into pwell 509c. The p-type VSS diffusion region 505d and the p-type I/O injector region 507d extend into pwell 509d.

In an embodiment, n-type guard rings 501a-501e can be formed from phosphorous. In other embodiments, n-type guard rings 501a-501e can be formed from other materials. In an embodiment, the p-type VSS diffusion region 505a, the p-type VSS diffusion region 505b, the p-type VSS diffusion region 505c, and the p-type VSS diffusion region 505d can be formed from boron. In other embodiments, the p-type VSS diffusion region 505a, the p-type VSS diffusion region 505b, the p-type VSS diffusion region 505c, and the p-type VSS diffusion region 505d can be formed from other materials. In an embodiment, the n-type I/O injector region 507a, the n-type I/O injector region 507b, the n-type I/O injector region 507c, and the n-type I/O injector region 507d can be formed from phosphorous. In other embodiments, the n-type I/O injector regions 507a, the n-type I/O injector region 507b, the n-type I/O injector region 507c, and the n-type I/O injector region 507d can be formed from other materials. In an embodiment, the pwells 509a-509d can be formed from boron. In other embodiments, the pwells 509a-509d can be formed from other materials. In an embodiment, the deep nwell 511 can be formed from phosphorous. In other embodiments, the deep nwell 511 can be formed from other materials. In an embodiment, the substrate 513 can be formed from silicon. In other embodiments, the substrate 513 can be formed from other materials.

In operation, the guard ring grid operates to mitigate latch up based on an efficient collection of carriers. For example, because of the illustrated guard ring grid structure, well resistance between guard ring pick-up points decreases. The decrease in resistance reduces voltage drop within the guard ring well and improves the efficiency of the collector terminal of the parasitic BJT. In particular, the well resistance is decreased between the guard ring pick-up points by integrating guard ring pick up points throughout the injector array.

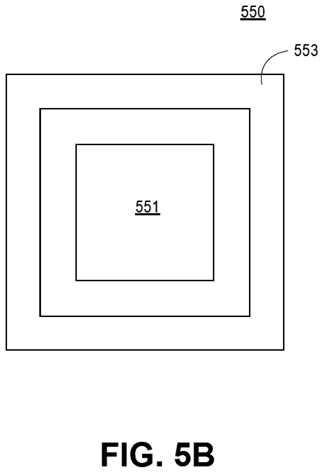

FIG. 5B shows an electronic system 550 that includes a guard ring grid according to an embodiment. In FIG. 5B the electronic system 550 includes core circuitry 551 and guard ring grid 553 (e.g., 401 in FIG. 4 or 501 in FIG. 5A).

Referring to FIG. 5B, the guard ring grid 553 is formed adjacent the core circuitry 551. In an embodiment, the core circuitry 551 can include various types of functional circuitry (e.g., internal logic circuitry, etc.). In an embodiment, by providing the guard ring grid 553 for the core circuitry 551, latchup caused by current flowing into the core circuit area can be mitigated.

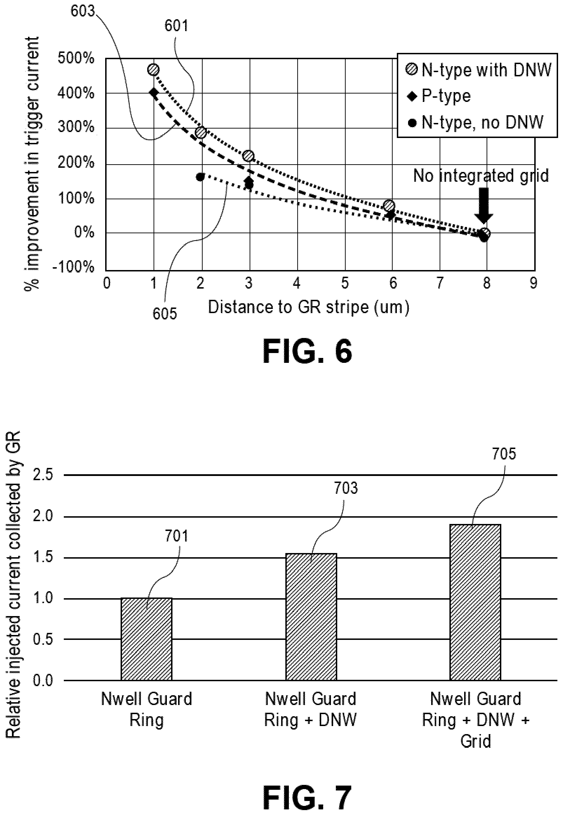

FIG. 6 is a graph of distance to guard ring versus improvement in trigger current for a plurality of types of devices according to an embodiment. FIG. 6 shows plots for an n-type device with a deep nwell 601, a p-type device 603, and an n-type device with no deep nwell 605.

Referring to FIG. 6, tighter guard ring grids (i.e. shorter distance between injector and guard ring stripe) are more robust, requiring more injected current before triggering the victims. In an embodiment, the trigger current can be improved by over 400 percent relative to previous approaches. In other embodiments, greater or less improvement can be achieved. In an embodiment, the benefits provided by n-type rings in the absence of a deep nwell can be less than the benefits provided when a deep nwell is present. In other embodiments, other results can be obtained. However, in an embodiment, significant benefits are provided by the herein described integrated grid approach whether or not DNW is available in the technology.

FIG. 7 is a graph shows the relative injected current collected for a plurality of types of devices according to an embodiment. FIG. 7 shows bars corresponding to a device with an nwell guard ring 701, nwell guard ring and deep nwell 703, and nwell guard ring, deep nwell and grid 705.

Referring to FIG. 7, the graph illustrates that in an embodiment improvement can be obtained in carrier collection by adding a DNW under the n-type guard ring. In addition, a further improvement can be obtained by integrating a guard ring grid with the injector array as described herein with reference to FIG. 5. It should be appreciated that the results shown in FIG. 7 are exemplary and in other embodiments, other results can be obtained.

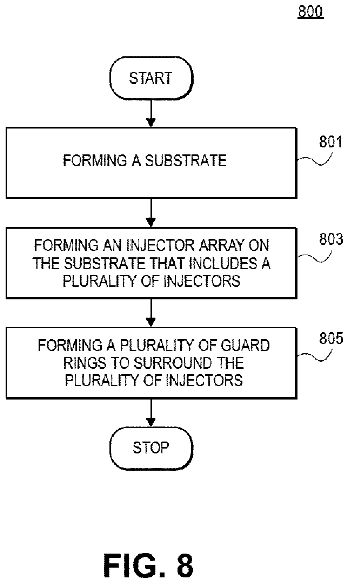

FIG. 8 shows a flowchart of a method for forming a latchup guard ring grid according to an embodiment. Referring to FIG. 8, the method includes, at 801, forming a substrate. At 803, forming an injector array on the substrate that includes a plurality of injectors. At 805, forming a plurality of guard rings to surround the plurality of injectors. In an embodiment, forming a plurality of guard rings includes forming each guard ring to define a cell of a guard ring grid. In an embodiment, forming a plurality of guard rings includes forming each cell of the guard ring grid to include an input/output (I/O) node, an isolated well and a guard ring well that encloses the I/O node and the isolated well. In an embodiment, the I/O node, the isolated well and the guard ring well constitute a bipolar junction transistor. In an embodiment, forming an injector array includes forming one of the plurality of injectors to be coupled to the I/O node. In an embodiment, forming the injector array includes forming the plurality of injectors to include an electrostatic discharge (ESD) protection device.

Implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the spirit and scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or all-around gate transistors such as nanoribbon and nanowire transistors. Although the implementations described herein may illustrate only planar transistors, it should be noted that the invention may also be carried out using nonplanar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO2) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO2), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

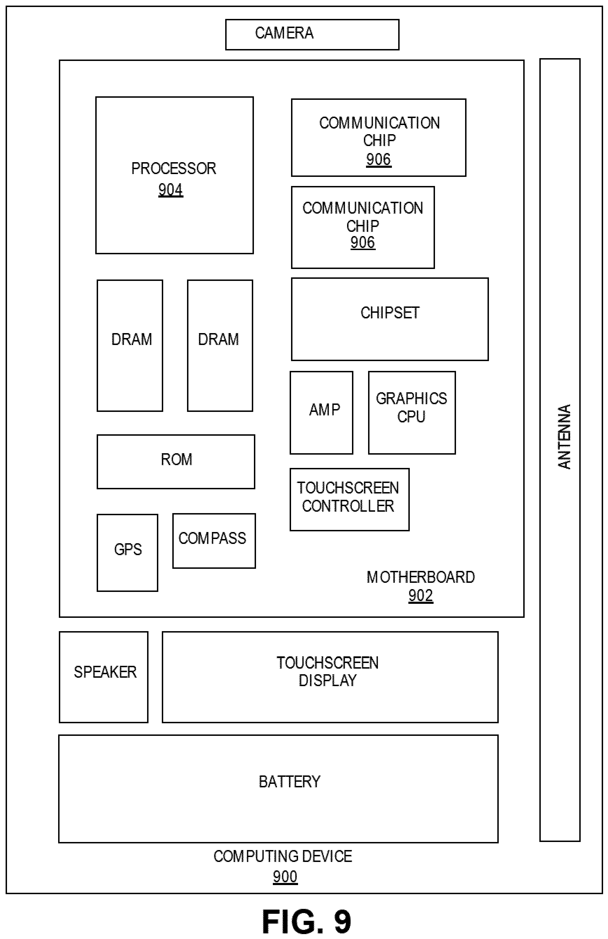

FIG. 9 illustrates a computing device 900 in accordance with one implementation of the invention. The computing device 900 houses a board 902. The board 902 may include a number of components, including but not limited to a processor 904 and at least one communication chip 906. The processor 904 is physically and electrically coupled to the board 902. In some implementations the at least one communication chip 906 is also physically and electrically coupled to the board 902. In further implementations, the communication chip 906 is part of the processor 904.

Depending on its applications, computing device 900 may include other components that may or may not be physically and electrically coupled to the board 902. These other components include, but are not limited to, volatile memory (e.g., DRAM), nonvolatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 906 enables wireless communications for the transfer of data to and from the computing device 900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 906 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 900 may include a plurality of communication chips 906. For instance, a first communication chip 906 may be dedicated to shorter range wireless communications such as Wi-Fi and Bluetooth and a second communication chip 906 may be dedicated to longer range wireless communications such as GPS, EDGE, GPRS, CDMA, WiMAX, LTE, Ev-DO, and others.

The processor 904 of the computing device 900 includes an integrated circuit die packaged within the processor 904. In some implementations of the invention, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 906 also includes an integrated circuit die packaged within the communication chip 906. In accordance with another implementation of the invention, the integrated circuit die of the communication chip includes one or more devices, such as MOS-FET transistors built in accordance with implementations of the invention.

In further implementations, another component housed within the computing device 900 may contain an integrated circuit die that includes one or more devices, such as MOS-FET transistors built in accordance with implementations of the invention.

In various implementations, the computing device 900 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 900 may be any other electronic device that processes data.

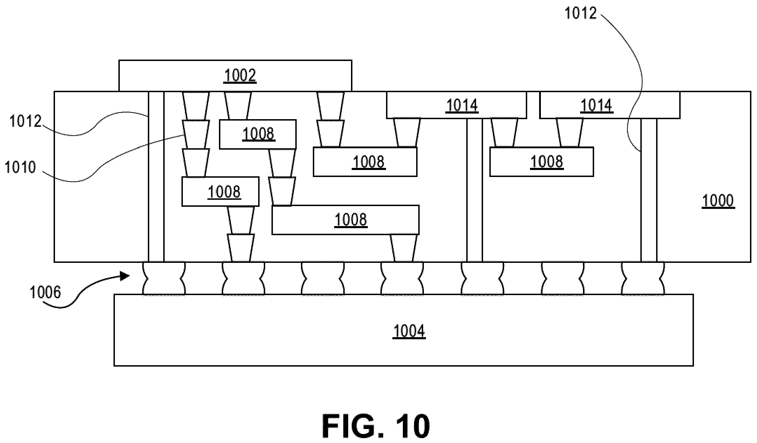

FIG. 10 illustrates an interposer 1000 that includes one or more embodiments of the invention. The interposer 1000 is an intervening substrate used to bridge a first substrate 1002 to a second substrate 1004. The first substrate 1002 may be, for instance, an integrated circuit die. The second substrate 1004 may be, for instance, a memory module, a computer motherboard, or another integrated circuit die. Generally, the purpose of an interposer 1000 is to spread a connection to a wider pitch or to reroute a connection to a different connection. For example, an interposer 1000 may couple an integrated circuit die to a ball grid array (BGA) 1006 that can subsequently be coupled to the second substrate 1004. In some embodiments, the first and second substrates 1002/1004 are attached to opposing sides of the interposer 1000. In other embodiments, the first and second substrates 1002/1004 are attached to the same side of the interposer 1000. And in further embodiments, three or more substrates are interconnected by way of the interposer 1000.

The interposer 1000 may be formed of an epoxy resin, a fiberglass-reinforced epoxy resin, a ceramic material, or a polymer material such as polyimide. In further implementations, the interposer may be formed of alternate rigid or flexible materials that may include the same materials described above for use in a semiconductor substrate, such as silicon, germanium, and other group III-V and group IV materials.

The interposer may include metal interconnects 1008 and vias 1010, including but not limited to through-silicon vias (TSVs) 1012. The interposer 1000 may further include embedded devices 1014, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 1000. In accordance with embodiments of the invention, apparatuses or processes disclosed herein may be used in the fabrication of interposer 1000.

Although specific embodiments have been described above, these embodiments are not intended to limit the scope of the present disclosure, even where only a single embodiment is described with respect to a particular feature. Examples of features provided in the disclosure are intended to be illustrative rather than restrictive unless stated otherwise. The above description is intended to cover such alternatives, modifications, and equivalents as would be apparent to a person skilled in the art having the benefit of the present disclosure.

The scope of the present disclosure includes any feature or combination of features disclosed herein (either explicitly or implicitly), or any generalization thereof, whether or not it mitigates any or all of the problems addressed herein. Accordingly, new claims may be formulated during prosecution of the present application (or an application claiming priority thereto) to any such combination of features. In particular, with reference to the appended claims, features from dependent claims may be combined with those of the independent claims and features from respective independent claims may be combined in any appropriate manner and not merely in the specific combinations enumerated in the appended claims.

The following examples pertain to further embodiments. The various features of the different embodiments may be variously combined with some features included and others excluded to suit a variety of different applications.
Example embodiment 1: A guard ring grid including a substrate an injector array coupled to the substrate including a plurality of injectors; and a plurality of guard rings that surround the plurality of injectors.
Example embodiment 2: The guard ring grid of example embodiment 1, wherein each guard ring defines a cell of the guard ring grid.
Example embodiment 3: The guard ring grid of example embodiment 2, wherein each cell of the guard ring grid includes an input/output (I/O) node, an isolated well and a guard ring well that encloses the I/O node and the isolated well.
Example embodiment 4: The guard ring grid of example embodiment 3, wherein the I/O node, the isolated well and the guard ring well constitute a bipolar junction transistor.
Example embodiment 5: The guard ring grid of claim 4, wherein one of the plurality of injectors is coupled to the I/O node.
Example embodiment 6: The guard ring grid of claim 1, wherein the plurality of injectors include an electrostatic discharge (ESD) protection device.
Example embodiment 7: The guard ring grid of claim 1, 2, 3. 4. 5 or 6 wherein the plurality of injectors include an output driver.
Example embodiment 8: An electronic system including a core circuitry, a peripheral circuitry coupled to the core circuitry, and a guard ring grid adjacent the peripheral circuitry, that includes a substrate an injector array coupled to the substrate including a plurality of injectors, and a plurality of guard rings that surround the plurality of injectors.
Example embodiment 9: The electronic system of example embodiment 8, wherein each guard ring defines a cell of the guard ring grid.
Example embodiment 10: The electronic system of example embodiment 9, wherein each cell of the guard ring grid includes an input/output (I/O) node, an isolated well and a guard ring well that encloses the I/O node and the isolated well.
Example embodiment 11: The electronic system of example embodiment 10, wherein the I/O node, the isolated well and the guard ring well constitute a bipolar junction transistor.
Example embodiment 12: The electronic system of claim 11, wherein one of the plurality of injectors is coupled to the I/O node.
Example embodiment 13: The electronic system of claim 8, wherein the plurality of injectors include an electrostatic discharge (ESD) protection device.
Example embodiment 14: The electronic system of claim 8, 9, 10, 11, 12 or 13 wherein the plurality of injectors include an output driver.
Example embodiment 15: A method includes forming a substrate forming an injector array coupled to the substrate including a plurality of injectors; and forming a plurality of guard rings that surround the plurality of injectors.
Example embodiment 16: The method of example embodiment 15, wherein forming a plurality of guard rings includes forming each guard ring to define a cell of a guard ring grid.
Example embodiment 17: The method of example embodiment 16, wherein forming a plurality of guard rings includes forming each cell of the guard ring grid to include an input/output (I/O) node, an isolated well and a guard ring well that encloses the I/O node and the isolated well.
Example embodiment 18: The example embodiment of claim 17, wherein the I/O node, the isolated well and the guard ring well constitute a bipolar junction transistor.
Example embodiment 19: The method of claim 18, wherein the forming an injector array includes forming one of the plurality of injectors to be coupled to the I/O node.
Example embodiment 20: The method of claim 15, 16, 17, 18 or 19 wherein the forming the injector array includes forming the plurality of injectors to include an electrostatic discharge (ESD) protection device.

## Claims

1. A guard ring grid, comprising:
a substrate
an injector array coupled to the substrate including a plurality of injectors; and
a plurality of guard rings that surround the plurality of injectors.

2. The guard ring grid of claim 1, wherein each guard ring defines a cell of the guard ring grid.

3. The guard ring grid of claim 2, wherein each cell of the guard ring grid includes an input/output (I/O) node, an isolated well and a guard ring well that encloses the I/O node and the isolated well.

4. The guard ring grid of claim 3, wherein the I/O node, the isolated well and the guard ring well constitute a bipolar junction transistor.

5. The guard ring grid of claim 3 or 4, wherein one of the plurality of injectors is coupled to the I/O node.

6. The guard ring grid of claim 1, 2, 3, 4 or 5, wherein the plurality of injectors include an electrostatic discharge (ESD) protection device.

7. The guard ring grid of claim 1, 2, 3, 4, 5 or 6, wherein the plurality of injectors include an output driver.

8. A method, comprising:
forming a substrate
forming an injector array coupled to the substrate including a plurality of injectors; and
forming a plurality of guard rings that surround the plurality of injectors.

9. The method of claim 8, wherein forming a plurality of guard rings includes forming each guard ring to define a cell of a guard ring grid.

10. The method of claim 9, wherein forming a plurality of guard rings includes forming each cell of the guard ring grid to include an input/output (I/O) node, an isolated well and a guard ring well that encloses the I/O node and the isolated well.

11. The method of claim 10, wherein the I/O node, the isolated well and the guard ring well constitute a bipolar junction transistor.

12. The method of claim 10 or 11, wherein the forming an injector array includes forming one of the plurality of injectors to be coupled to the I/O node.

13. The method of claim 8, 9, 10, 11 or 12, wherein the forming the injector array includes forming the plurality of injectors to include an electrostatic discharge (ESD) protection device.
